# EUROPEAN PATENT APPLICATION

(11) **EP 4 793 313 A1**
(43) Date of publication of application: **19.08.2026**
(21) Application number: 26158174.8
(22) Date of filing: 12.02.2026
(51) Int. Cl.: C08L 23/0807, C08L 53/00, C08J 5/18, H10F 19/80

(54) **POLYMER COMPOSITION FOR PHOTOVOLTAIC MODULES**

(30) Priority: 14.02.2025 CN 202510165487
(71) Applicant: Kraton Polymers Nederland B.V., 1322 CE Almere (NL)
(72) Inventor: NIU, Yaming, Houston, 77084 (US); WANG, Jiwen, Houston, 77084 (US); YANG, Huixian, Houston, 77084 (US); ZHOU, Guanwei, Houston, 77084 (US)
(74) Representative: Henkel & Partner mbB

(57) **Abstract**

The disclosure relates to an encapsulant film for photovoltaic modules comprising: POE and at least one hydrogenated block copolymer. The hydrogenated block copolymer is selected from: a multi-arm hydrogenated block copolymer (MABC) having a structure of ("R")ₙX, X is residue of a coupling agent and n = 4 to 20, a hydrogenated styrenic block copolymer (HSBC), and combinations thereof. The HSBC contains at least one block "R" and at least one block "S." Each block "S" is composed of vinyl aromatic units, and each block "R" is composed of hydrogenated diene units. The HSBC has a vinyl aromatic unit (VAC) content of < 40 wt.%. The encapsulant film after curing has a static friction coefficient of > 0.39, and a dynamic friction coefficient of > 0.40. The encapsulant film provides improved anti-slip properties, and a balance of transparency and mechanical properties.

## Description

### FIELD

The disclosure relates to polymer compositions, methods of preparation, and applications thereof in photovoltaic modules.

### BACKGROUND

Photovoltaic (PVs) modules are enclosed in a matrix of polymeric materials such as encapsulant films for protection and support. The PV module contains a semiconductor material, such as silicon, which converts light into electric energy. Encapsulant films protect the fragile silicon solar cells and bond them to the glass cover and back sheet, providing mechanical and chemical protection that enhances the module's durability and efficiency.

Encapsulant film compositions based on polyolefin elastomers (POEs) provide properties such as aging resistance and chemical stability. However, POE-based compositions exhibit low polarity, leading to slippage on glass and silicon surfaces with the polymer film moving out of alignment with the glass cover and silicon cells. Such slipping can undermine the integrity and performance of the PV module.

Various attempts have been made to address the slipping issue associated with POE-based encapsulant films. These include the addition of polar additives to the compositions, grafting polar groups onto the POE, creating micro-textures on the film surface to increase friction, and using spot-welding techniques to adhere the encapsulant film to the silicon plates.

There is still a need for a POE-based composition with improved anti-slip properties and optimal balance of transparency and mechanical performance for use in PV modules.

### SUMMARY

In a first aspect, the disclosure relates to an encapsulant film for photovoltaic modules comprising, consisting essentially of, or consisting of: 100 phr of a polyolefin elastomer (POE) comprising a copolymer of ethylene and at least one alpha-olefin having 3 to 20 carbon atoms; and 0.1 to 10 phr of a hydrogenated block copolymer. The hydrogenated block copolymer is selected from: (i) a multi-arm hydrogenated block copolymer (MABC), and (ii) a hydrogenated styrenic block copolymer (HSBC), and (iii) mixtures thereof. The MABC has a general structure ("R")ₙX, where X is a residue of a coupling agent and n is an integer from 4 to 20. The HSBC comprises at least one block "S" and at least one block "R", where each block "S" is composed of vinyl aromatic units and has a molecular weight (Mₚ) of 70 to 130 kg/mol, measured according to ASTM D5296-19. The HSBC has a vinyl aromatic unit (VAC) content of < 40 wt.%, measured by ¹H NMR. Each block "R" comprises hydrogenated diene units. After curing, the encapsulant film has a static friction coefficient > 0.39, and a dynamic friction coefficient > 0.45, both measured according to ASTM D1894. Each of the above transitional terms (e.g., 'comprising,' 'consisting essentially of,' and 'consisting of') is intended to carry its conventional meaning as understood in patent law, or defined when appropriate.

In a second aspect, the POE has at least one of: a melt flow index (MFI) of < 50 g/10 min, measured at 190°C with 2.16 kg load, according to ASTM D1238; and a density of 0.860 to 0.910 g/cm³, measured according to ASTM D1505.

In a third aspect, the POE is selected from ethylene-1-butene copolymer, ethylene-octene copolymer, and mixtures thereof.

In a fourth aspect, the disclosure also relates to a method of making an encapsulant film for use in photovoltaic modules. The method comprising, consisting essentially of, or consisting of: providing a polymer composition comprising: (a) 100 phr of the POE, (b) 0.1 to 10 phr of the hydrogenated block copolymer, (c) 0.1 to 5 phr of a cross-linking agent, and (d) 0.1 to 10 phr of at least one additive. Forming the encapsulant film by casting, electrospinning, extrusion, compression, or coating; and curing the encapsulant film at a temperature of 80 to 220°C.

### DETAILED DESCRIPTION

The following terms will be used throughout the specification.

"Consisting essentially of" means that the composition primarily includes the recited components and may additionally contain one or more components that do not materially affect the novel characteristics or intended function of the invention. In embodiments, such additional components are present in amounts of < 30 wt.%, < 20 wt.%, or < 10 wt.%, based on total weight of the composition.

"At least one of A, B, and C" means one or more members selected from the group consisting of A, B, and C. Thus, it includes A only, B only, C only, A and B, A and C, B and C, and A, B, and C.

A list of embodiments recited as "A, B, or C" is interpreted to include A only, B only, C only, or any combination of two or more of A, B, and C, unless the context clearly indicates otherwise.

"Any of A, B, or C" means one member selected from A, B, and C.

If used, "any of A, B, and C" means one or more members selected from A, B, and C, and is intended to have the same scope as "at least one of A, B, and C."

"Vinyl aromatic unit content" or VAC of a block copolymer refers to the weight % of polymerized vinyl aromatic monomers, e.g., styrene in the block copolymer, calculated by dividing the sum of molecular weight of all vinyl aromatic units by total molecular weight of the block copolymer. VAC can be determined using proton nuclear magnetic resonance (¹H NMR) and ¹³C NMR. VAC sometimes is used interchangeably with polystyrene content (PSC).

"Butylene unit content" refers to the content, in weight %, of the butylene units ("B") in a hydrogenated block copolymer. The butylene units are obtained / formed by polymerization of 1,3-butadiene monomer via 1,2-addition, followed by hydrogenation. The 1,3-butadiene monomer can also polymerize through 1,4-addition, which upon hydrogenation results in ethylene units ("E"). Both butylene and ethylene units can be part of the hydrogenated block copolymer which can also contain vinyl aromatic units and/or ethylene-propylene units in any order. The butylene unit content can be measured by ¹H NMR and ¹³C NMR.

"Coupling efficiency (CE)" refers to the weight of coupled polymer molecules divided by the total weight of both coupled and uncoupled polymer molecules, expressed as a percentage (%). CE can be used to determine the amount of diblock content in the overall block copolymer. For example, if the coupling efficiency is 80%, the polymer will contain 20 wt.% diblock and 80 wt.% triblock and multi-arm blocks.

"Molecular weight" or Mw refers to the styrene equivalent molecular weight in kg/mol of a polymer block or a block copolymer. Mw can be measured with gel permeation chromatography (GPC) using polystyrene calibration standards, such as is done according to ASTM D5296-19. The GPC detector can be an ultraviolet or refractive index detector or a combination thereof. The chromatograph is calibrated using commercially available polystyrene molecular weight standards. Mw of polymers measured using GPC so calibrated are styrene equivalent molecular weights or apparent molecular weights. Mw expressed herein is measured at the peak of the GPC trace-and commonly referred to as styrene equivalent "peak molecular weight," designated as Mₚ.

"Mₚ of a block segment" in a block copolymer refers to the GPC molecular weight corresponding to polymer chains or chain segments comprising the monomer units of that block. For block copolymers, the Mₚ of a given block may be determined from a gel permeation chromatography (GPC) analysis conducted in accordance with ASTM D5296, using calibration with polystyrene standards, by identifying a GPC signal attributable to the monomer units of the block. Such identification may be carried out using a detector selective for the monomer units of the block, such as an ultraviolet (UV) detector for vinyl aromatic blocks, optionally in combination with a refractive index detector.

"HSBC" refers to a hydrogenated styrenic block copolymer derived from the polymerization of 1,3-butadiene and/or isoprene monomers with vinyl aromatic monomers. In HSBC, a substantial proportion of the double bonds originating from the 1,3-butadiene and/or isoprene units are hydrogenated, achieving a hydrogenation level exceeding 95% or even 99%. The aromatic bonds, however, are hydrogenated to a level ranging from 0% to 15%.

"Hydrogenation level" refers to the level (in percentage) of saturation of the double bonds (e.g., olefinic, aromatic, etc.) into the block copolymer, can be measured by ¹H NMR.

"Residual unsaturation" or RU refers to the levels of unsaturation, i.e., carbon-carbon double bonds per gram of a block copolymer. RU can be measured using ¹H NMR or ozonolysis titration.

"Unit" refers to the structural building block derived from one or more polymerized monomers, representing the repeating entity that forms part of the polymer or copolymer chain. Unlike a "monomer," which is the individual molecule before polymerization, a "unit" is the transformed version of the monomer after undergoing the polymerization process.

"Photovoltaic module" is used interchangeably with "solar panel" or "collector," refers to an assembly that converts solar energy into electrical energy.

"phr" relates to parts by weight of a particular ingredient per 100 parts by weight of another ingredient, typically as the main component or the component present in the largest amount of a composition. In this disclosure, the largest component is the POE.

The disclosure relates to an encapsulant film comprising a polyolefin elastomer (POE) and at least one hydrogenated block copolymer selected from: (i) a multi-arm hydrogenated block copolymer (MABC); (ii) a hydrogenated styrenic block copolymer (HSBC); and (iii) mixtures thereof. The encapsulant film provides improved anti-slip properties as well as desirable transparency and mechanical properties. The term "polymer composition" as used herein refers to the composition of the encapsulant film.

(Polyolefin Elastomers (POEs)): POE is a copolymer of ethylene and at least one C₃-C₂₀ α-olefin monomer. The POE can be linear or branched copolymer and contain an α-olefin units from 5 - 50, or 10 - 45, or 15 - 35, or 20 - 35, or > 10, or < 50 wt.%, based on total weight of the POE, remainder being ethylene units.

In embodiments, the C₃-C₂₀ α-olefin monomer is any of linear, branched, or cyclic olefins. Examples of α-olefin monomers include propylene, isobutylene, 1-butene, 1-hexene, 1-pentene, 4-methyl-1-pentene, 1-heptene, octene, 1-nonene, 1-decene, 1-dodecene, 1-tetradecene, 1-hexadecene, 1-octadecene, 1-eicosene, and the like. In embodiments, POE further comprise C₄-C₁₈ diolefin and/or alkenylbenzene.

Examples of POEs include ethylene / propylene copolymers, ethylene / 1-butene copolymers, ethylene / 1-hexene copolymers, ethylene / octene copolymers, ethylene / α-olefin / diene modified interpolymers (e.g., ethylene / propylene / diene modified interpolymers, ethylene / propylene / octene terpolymers, etc.), propylene / ethylene / 1-butene copolymers, propylene / ethylene / ethylidene norbornene copolymers, propylene / ethylene / 1-hexene copolymers, propylene / ethylene / 1-octene copolymers, propylene / ethylene / styrene copolymers, and the like.

In embodiments, the POE is functionalized with at least one functional group selected from the group consisting of maleic anhydride, acrylic acid, methacrylic acid, crotonic acid, fumaric acid, fumaric acid anhydride, maleic acid, citraconic acid, and mixtures thereof. The functional group can be introduced into the POE by copolymerizing functional group containing commoner during preparation of the POE.

In embodiments, the POE has a density of 0.860 - 0.910, or 0.865 - 0.905, or 0.870 - 0.900, or 0.865 - 0.898 g/cm³, measured according to ASTM D1505.

In embodiments, the POE has a melt flow index (MFI) of < 50, or < 40, or < 30, or < 20, or > 1, or 1 - 50, or 2 - 40, or 3 - 30, or 1 - 30, or 2 - 20, or 4 - 25, or 1 - 10 g/10 min, measured at 190°C with 2.16 kg load, according to ASTM D1238.

In embodiments, the POE has a glass transition temperature (T_{g}) of < -10°C, or < -20°C, or < -30°C, or > -60°C, or -60 to 0°C, or -55 to -20°C, measured by differential scanning calorimetry (DSC).

In embodiments, the POE has a melting temperature of > 40°C, or > 50°C, or 40 - 90°C, or 50 - 80°C, or 55 - 75°C, or 58 - 75°C, measured by DSC.

(Hydrogenated Block Copolymer): In embodiments, the hydrogenated block copolymer is selected from a multi-arm hydrogenated block copolymer (MABC), a hydrogenated styrenic block copolymer (HSBC), and combinations thereof.

The MABC can be prepared by polymerizing one or more of diene monomers and, optionally, one or more vinyl aromatic monomers, followed by hydrogenation.

The HSBC can be prepared by polymerizing one or more diene monomers and one or more vinyl aromatic monomers, followed by hydrogenation.

In embodiments, the vinyl aromatic monomer is selected from the group consisting of styrene, para-methylstyrene, para-ethylstyrene, para-n-propylstyrene, para-iso-propylstyrene, para-n-butylstyrene, para-sec-butylstyrene, para-iso-butylstyrene, para-t-butylstyrene, isomers of para-decylstyrene, isomers of para-dodecylstyrene, ortho-substituted styrene, meta-substituted styrene, alpha-methylstyrene, 1,1-diphenylethylene, and mixtures thereof.

In embodiments, the diene monomer is selected from the group consisting of isoprene, 1,3-butadiene, 2,3-dimethyl-1,3-butadiene, 1-phenyl-1,3-butadiene, 1,3-pentadiene, 1,3-hexadiene, 3-butyl-1,3-octadiene, farnesene, myrcene, piperylene, cyclohexadiene, and mixtures thereof.

The hydrogenated block copolymer is used in amounts of 0.05 - 10, or 0.1 - 10, or 0.3 - 8, or 0.5 - 5 phr, based on 100 phr of the POE.

(Multi-Arm Hydrogenated Block Copolymers (MABCs)): In embodiments, the hydrogenated block copolymer is a MABC having a general structure of ("R")ₙX; each block "R" is composed of hydrogenated diene units and, optionally, vinyl aromatic units, X represents the residue of a coupling agent, and n is an integer from 4 to 20. The hydrogenated diene units, prior to hydrogenation, are derived from polymerized diene monomers, while the vinyl aromatic units, if present, are derived from polymerized vinyl aromatic monomers.

In embodiments, each block "R" is selected from E/B, E/B/S, EP/MB, EP/MB/S, E/B/EP/MB, and combinations thereof.

In embodiments, block "R" is an E/B block composed of ethylene ("E") units and butylene ("B") units, which correspond to hydrogenated 1,4-butadiene and hydrogenated 1,2-butadiene units, respectively.

In embodiments, block "R" is an E/B/S block composed of ethylene ("E") units, butylene ("B") unit, and vinyl aromatic ("S") units.

In embodiments, block "R" is an EP/MB block composed of ethylene-propylene (EP) units and methylene-butylene (MB) units. Each EP unit is derived from hydrogenation of a 1,4-isoprene unit, and each MB unit is derived from hydrogenation of 3,4-isoprene and/or 1,2-isoprene units. In embodiments, the methylene-butylene (MB) units are present in the EP/MB block in amounts of < 10, or < 8, or < 5 wt.%, based on total weight of the block EP/MB.

In embodiments, block "R" is an EP/MB/S block composed of ethylene-propylene (EP) units, methylene-butylene (MB) units, and vinyl aromatic ("S") units.

In embodiments, block "R" is an E/B/EP/MB block composed of ethylene ("E") units, butylene ("B") units, ethylene-propylene (EP) units, and methylene-butylene (MB) units.

In embodiments, the MABC consists of coupled hydrogenated polyisoprene arms having a general structure of (EP/MB)ₙX.

In embodiments, the MABC consists of a coupled hydrogenated polybutadiene arms having a general structure of (E/B)ₙX.

In embodiments, the MABC is characterized as having no vinyl aromatic units.

The MABC can be prepared by sequential (or successive) polymerization, for example by living anionic polymerization of monomers in solution in the presence of an initiator or catalyst. The polymerization can be carried out with stepwise addition of monomers and initiator, followed by coupling of the resulting polymer with a coupling agent and subsequent hydrogenation.

In embodiments, each block "S," if present, remains essentially unhydrogenated, while blocks such as E/B and EP/MB are hydrogenated. The block "S," if present, can have a hydrogenation level of < 30%, or < 20%, or < 10%, or < 5%, based on total double bonds present in the block "S". Each block E/B and block EP/MB independently has a hydrogenation level of > 80%, or > 85%, or > 90%, or > 95%, or > 98%, or > 99%, or up to 100%, based on total double bonds present in the respective block.

In embodiments, the MABC has a MFR of 2 - 30, or 4 - 20, or 6 - 15, or > 2, or < 15 g/10 min at 200°C with 5 kg load, measured according to ASTM D1238.

In embodiments, the MABC has a density of 0.880 - 0.915, or 0.885 - 0.910, or 0.890 - 0.905 g/cm³, measured according to ASTM D792.

In embodiments, the MABC has a coupling efficiency (CE) of > 80%, or > 85%, or > 90%, or > 92%, or 80 - 99%, or 85 - 98%, or 90 - 99%.

In embodiments, the MABC has a residual unsaturation (RU) of 0.01 - 1, or 0.02 - 0.8, or 0.04 - 0.5, or 0.01 - 0.1 meq/g, measured by ¹H NMR.

In embodiments, the MABC has a molecular weight (Mₚ) of 300 - 700, or 350 - 650, or 400 - 650, or 420 - 600, or > 300, or > 400, or > 440, or < 700, or < 600 kg/mol.

In embodiments, the MABC has a diblock content of up to 25 wt.%, or 1 - 20, or 3 - 15, or > 1, or < 15 wt.%, based on total weight of the MABC.

In embodiments, the MABC is a block copolymer containing coupled hydrogenated polyisoprene arms having a general structure (EP/MB)ₙX; and has a MFR of 4 - 20 g/10 min at 200°C/5 kg, a CE of > 90%, a RU of 0.01 - 0.1 meq/g, a Mₚ of 400 - 650 kg/mol, a diblock content of 3 - 15 wt.%, and a density of 0.890 - 0.905 g/cm³.

In embodiments, the MABC, when present, is used in amounts of 0.05 - 10, or 0.1 - 10, or 0.3 - 8, or 0.5 - 5 phr, based on 100 phr of the POE.

(Hydrogenated Styrenic Block Copolymers (HSBCs): In embodiments, the hydrogenated block copolymer is a HSBC obtained by hydrogenating a styrenic block copolymer (SBC) precursor. The SBC precursor can be a triblock, tetrablock, pentablock, and mixtures thereof.

In embodiments, the HSBC is a linear or branched (multi-armed) block copolymer comprising at least one block "S," which is a polymer block of a vinyl aromatic monomer, and at least one block "R" composed of hydrogenated diene units and, optionally, vinyl aromatic units.

In embodiments, the HSBC has a general structure selected from: S-R, (S-R)ₙX, S-R-S, S-R-S-R, R-S-R-S-R, (R-S-R)ₙX, S-R-S-R-S, (S-R-S)ₙX, and mixtures thereof; where n is an integer from 2 to 30 or 2 to 20, or 2 to 10, and X represents residue of a coupling agent. Each block "S" and "R," and coupling agent X, are as described above for the MABC.

In embodiments, the HSBC has a total VAC of < 40, or < 35, or > 5, or > 10, or 5 - 40, or 5 - 35, or 5 - 25, or 10 - 25 wt.%, based on total weight of the HSBC.

In embodiments, the HSBC has a CE of > 65%, or > 70%, or 60 - 98%, or 65 - 95%, or 75 - 95%.

In embodiments, each block "S" has a molecular weight (Mₚ) of 2 - 30, or 3 - 25, or 2 - 25, or 3 - 20, or 5 - 10, or 70 - 130, 70 - 130, or 80 - 120, or 85 - 110, or > 2, or > 70, or < 30, or < 130 kg/mol. In preferred embodiments, the block "S" has a Mₚ in the range of 70 - 130 kg/mol, or 80 - 120 kg/mol, or 85 - 110 kg/mol.

In embodiments, the HSBC has a molecular weight (Mₚ) of 40 - 300, or 50 - 290, or 60 - 250, or 40 - 220, or 50 - 150, or > 50, or < 300 kg/mol.

In embodiments, the HSBC has a melt flow rate (MFR) of 0.1 - 250, or 0.1 - 50, or 0.1 - 30, or 0.5 - 25, or > 0.1, or < 250 g/10 min at 230°C with 5 kg load, measured according to ASTM D1238. In embodiments, the HSBC has a melt flow rate (MFR) of 0.1 - 250, or 0.1 - 50, or 0.1 - 30, or 0.5 - 25, or > 0.1, or < 250 g/10 min at 230°C with 2.16 kg load, measured according to ASTM D1238.

In embodiments, the HSBC is a styrene-ethylene/propylene (S-EP/MB) block copolymer having a molecular weight (Mₚ) of block "S" of 70 - 130 kg/mol; a molecular weight (Mₚ) of the HSBC of 80 - 150 kg/mol; a VAC of 25 - 45 wt.%; and a MFR of 0.1 - 10 g/10 min at 230°C/5 kg.

In embodiments, the HSBC, when present, is added in amounts of 0.05 - 10, or 0.1 - 10, or 0.5 - 8, or 0.5 - 5 phr, based on 100 phr of the POE.

(Preparation of Hydrogenated Block Copolymers): The hydrogenated block copolymer, whether a MABC or a HSBC, can be prepared by sequential polymerization, e.g., anionic polymerization. In such processes, the MABC is obtained by polymerization of one or more conjugated diene monomers, whereas the HSBC is obtained by polymerization of one or more conjugated diene monomers together with one or more vinyl aromatic monomers, followed in each case by hydrogenation. The polymerization can be carried out at a temperature of -30°C to 180°C, or 10°C to 150°C, or 30°C to 120°C, under an inert atmosphere, such as nitrogen or under pressure of 0.5 - 65 bars, for < 12 hours, or from 5 minutes to 5 hours, depending on factors including temperature, concentration of monomers, molecular weights of each block, etc. The polymerization can be conducted in the presence of one or more organic solvents, e.g., ether, benzene, toluene, xylene, ethylbenzene, cyclohexane, methylcyclohexane, etc. After formation of the block copolymer and completion of the coupling reaction, the reaction mixture can optionally be treated with a proton-donating terminating agent, e.g., water, carbon dioxide, hydrogen, alcohol, phenols, or linear saturated aliphatic mono- or di-carboxylic acids, to deactivate the polymer initiator prior to hydrogenation. Following polymerization, the resulting block copolymer is subjected to hydrogenation to produce the hydrogenated block copolymer.

In embodiments, the coupling agent employed for the preparation of the hydrogenated block copolymer (MABC or HSBC) includes bi- or polyfunctional compounds, for example divinylbenzene, halides of aliphatic or araliphatic hydrocarbons, such as 1,2-dibromoethane, bis(chloromethyl)benzene, silicon tetrachloride, dialkyl- or diarylsilicon dichloride, alkyl- or arylsilicon trichloride, tin tetrachloride, alkylsilicon methoxides, alkyl silicon ethoxides, polyfunctional aldehydes, such as terephthalic dialdehyde, ketones, esters, anhydrides, or epoxides. Examples include methyltrimethoxysilane (MTMS), methyltriethoxysilane (MTES), tetramethoxysilane (TMOS), vinyltrichlorosilanes, vinyltrimethoxysilane, vinyltriethoxysilane, vinyltriacetoxysilane, vinylmethyldiethoxysilane, vinylmethyldimethoxysilane, 2-(3,4-epoxycyclohexyl)ethyltrimethoxysilane, gamma-chloropropylmethoxysilane, ethylene-based tris(beta-methoxyethoxy)silane, gamma-methacryloxypropyltrimethoxysilane, ethylene-based triacetoxysilane, (3-glycidoxypropyl)trimethoxysilane, gamma-glycidoxypropyltrimethoxysilane, gammaaminopropyltriethoxysilane, anilino-methyl-triethoxysilane, 3-(trimethoxysilyl)propyl-2-methyl-2-acrylate, octyltrimethoxysilane, triacetoxyvinylsilane, triphenylvinylsilane vinyltrimethylsilane, 3-(trimethoxysilyl)propyl methacrylate, tris(2-methoxyethoxy)vinylsilane, gamma-mercaptopropyltrimethoxysilane, gamma-chloropropyltrimethoxysilane, isocyanatopropyltriethoxysilane, ureidopropyltrimethoxysilane, phenyltrimethoxysilane, octyltriethoxysilane, tetramethoxysilane, bis(trimethoxysilylpropyl)amine, bis(gamma-trimethoxysilylpropyl)ethylenediamine, and mixtures thereof.

(Cross-linking Agents): In embodiments, the polymer composition further comprises a cross-linking agent selected from the group consisting of organic peroxides, sulfur based compounds, isocyanates, polycarbodiimides, metal-based catalysts, and mixtures thereof.

In embodiments, the cross-linking agent is an organic peroxide selected from dialkyl peroxides, alkyl aryl peroxides, diaryl peroxides, hydrogen peroxides, diacyl peroxides, peroxy esters, ketone peroxides, peroxycarbonates, peroxy ketals, and mixtures thereof.

Examples of organic peroxides include 1,1-bis(t-butylperoxy)-3,3,5-trimethylcyclohexane, t-butyl peroxycarbonate-2-ethylhexyl ester, tert-butyl peroxybenzoate, 1,1-bis(tert-butylperoxy)-3,3,5-trimethylcyclohexane, 2,5-dimethyl-2,5-(bis-tert-butylperoxy)hexane, 1,1-bis(tert-amylperoxy)cyclohexane, 1,1-bis(tert-butylperoxy)cyclohexane, 1,1-bis(t-amylperoxy)-3,3,5-trimethylcyclohexane, 2,2-bis(t-butylperoxy)butane, tert-amyl peroxy 2-ethylhexyl carbonate, tert-amyl peroxy carbonate, t-butyl peroxy 3,3,5-trimethylhexanoate, tert-butyl isopropyl peroxycarbonate, tert-butylperoxy 2-ethylhexyl carbonate, monoperoxycarbonate, 2,5-dimethyl-2,5-(bis-tert-butylperoxy)hexane, 2,2-bis(tert-butylperoxy)butane, tert-pentyl 2-ethylhexylcarbonate, 2,5-dimethyl-2,5-bis(benzoylperoxy)-hexane, tert-pentylperoxy carbonate, tert-butylperoxy 3,3,5-trimethylhexanoate, dicumyl peroxide, benzoyl peroxide, tert-butyl peroxyacetate, tert-butyl cumyl peroxide, di-tert-butyl peroxide, cumene hydroperoxide, and mixtures thereof.

In embodiments, the polymer composition further comprises a co-cross-linking agent selected from one or more multifunctional acrylates, (e.g., trimethylolpropane triacrylate, trimethylolpropane trimethacrylate, pentaerythritol triacrylate, etc.), triallyl cyanurate, triallyl isocyanurate, N,N'-m-phenylene bismaleimide, triallyl trimellitate, ethylene glycol dimethacrylate, 1,2-polybutadiene, zinc diacrylate, and mixtures thereof.

In embodiments, the polymer composition comprises the cross-linking agent, the co-cross-linking agent, or combinations thereof, in a total amounts of 0.05 - 5, or 0.1 - 4, or 0.5 - 3, or 0.1 - 2 phr, based on 100 phr of the POE.

(Optional Additives): In embodiments, the polymer composition further comprises one or more additives selected from the group consisting of antioxidants, anti-ozonants, UV stabilizers, UV absorbers, flame retardants, coupling agents (as described above), processing aids, adhesion promoters, colorants, pigments, anti-blocking agents, anti-static agents, moisture scavengers, metal deactivators, nucleating agents, clarifiers, optical brighteners, acid scavengers, fillers, tackifiers, plasticizers, wavelength-shifting agents, film forming additives, viscosity modifiers, wetting agents, and mixtures thereof.

In embodiments, the antioxidant is selected from the group consisting of phenolics, phosphates, sulfur-based, quinolines, and mixtures thereof. Examples of antioxidants include n-octadecyl alcohol beta-[3,5-di-tert-butyl-4-hydroxyphenyl]propionate, pentaerythritol tetrakis[beta-(3,5-di-tert-butyl-4-hydroxyphenyl) propanoate, bis(3,5-di-tert-butyl-4-hydroxypropanoyl)hydrazine, 2,2'-oxamido-bis[ethyl-3-(3,5-di-tert-butyl-4-hydroxyphenyl)]propanoate, N,N'-hexamethylenebis (3,5-di-tert-butyl-4-hydroxyphenylpropionamide), 1,3,5-tris(3,5-di-tert-butyl-4-hydroxybenzyl), 1,3,5-triazine-2,4,6(1H,3H,5H)-trione, triethylene glycol bis[3-(3-tert-butyl-5-methyl-4-hydroxyphenyl) propionate], 4,6-bis(octan sulfur methyl) o-cresol, tris(2,4-di-tert-butylphenyl)phosphite, bis[2 ,4-di-tert-butylphenyl]pentaerythritol phosphorus acid ester, bis(2,6-di-tert-butyl-4-methylphenyl) pentaerythritol phosphorus acid ester, distearylpenta-di-phosphite, and mixtures thereof.

In embodiments, the UV stabilizer is selected from the group consisting of hindered amine light stabilizers (HALS), benzophenones, triazines, benzotriazoles, and mixtures thereof. Examples of UV stabilizers include 2,4-dihydroxybenzophenone, 2-hydroxy-4-methoxybenzophenone, 2-hydroxy-4-n-octyloxybenzophenone, 2-hydroxy-4-n-octylbenzophenone, 2-(2'-hydroxy-3',5'-di-tert-phenyl)-5-chlorinate benzotriazole, 2-(3',5'-di-tert-amyl-2'-hydroxyphenyl) benzotriazole, 2-(2'-hydroxy-5'-methylphenyl) benzotriazole, 2,4,6-tris(2'-n-butoxyphenyl)-1,3,5-triazine, 2,2-tetramethylenebis (3,1-benzoxazin-4-one), 2,2'-dihydroxy-4,4'-dimethoxybenzophenone, 2-hydroxy-4-methoxy-4-carboxybenzophenone, 2-(2-hydroxy-5-methylphenyl)benzotriazole, phenyl salicylate, p-octylphenyl salicylate, 2-(2'-hydroxy-3'-tert-butyl-5'-methylphenyl)-5-chlorobenzortriazole, 2-(2H-benzotriazol-2-yl)-4,6-ditertpentylphenol, and mixtures thereof.

Examples of suitable plasticizers include liquid diene polymers, aliphatic acid esters, hydrocarbon processing oil, tall oil pitch and modified tall oil pitch, polyolefin oil, naphthenic oil, paraffinic oil, aromatic mineral oils, phthalates, azelates, adipates, and the like.

In embodiments, the total amount of additive(s), when present, is up to 15 phr, or 0.1 - 10, or 0.5 - 5, or 0.2 - 4, or 0.1 - 3 phr, based on 100 phr of the POE.

(Optional Polymers): In embodiments, the encapsulant film further comprises one or more polymers other than the POE, the MABC, and the HSBC. Examples of such polymers include poly(ethylene-vinyl acetate), polyvinylbutyrals, ethylene propylene diene monomer (EPDM), thermoplastic polyurethane (TPU), polyurethanes, ionomers, polyvinyl chlorides (PVC), polyethylenes, thermoplastic polyolefins (TPO), ethylene-methyl acrylate copolymers, ethylene-butyl acrylate copolymers, silicone elastomers, epoxy resins, and mixtures thereof.

In embodiments, when present, the (optional) polymer is included in amounts of up to 20 phr, or 0.5 - 15, or 1 - 10, or 0.5 - 5, or 3 - 12 phr, based on 100 phr of the POE.

(Polymer Compositions): The polymer composition, based on 100 phr of the POE, comprises: (a) POE, (b) 0.1 - 10 phr of at least one hydrogenated block copolymer, (c) up to 5 phr of a cross-linking agent, (d) up to 15 phr of at least one additive; alternatively, (a) POE, (b) 0.1 - 10 phr of at least one hydrogenated block copolymer, (c) 0.1 - 5 phr of cross-linking agent, (d) 0.1 - 10 phr of at least one additive, (e) up to 20 phr of optional polymers.

In embodiments, the POE is present in the polymer composition at a weight ratio of POE to hydrogenated block copolymer ranging from 100:0.1 to 100:20, or 100:0.5 to 100: 15, or 100:1.0 to 100:10, or 100:0.5 to 100:5, or 100:0.5 to 100:3.

(Preparation of Encapsulant Films): The encapsulant film is produced from the polymer composition using methods known in the art. In embodiments, the components, e.g., POE, hydrogenated block copolymer, cross-linking agent(s), and optional additives are mixed together prior to film formation. In other embodiments, the polymer composition is prepared using a two package system. The first package includes a pre-mix containing the POE and at least one hydrogenated block copolymer. This pre-mix is compounded as a master batch at a temperature of 140 to 200°C and does not contain any cross-linking agents. The second package contains additional POE, the cross-linking agent(s), and optional additives. The first and second packages are subsequently compounded together at a temperature of 50 to 120°C to form the final polymer composition. In embodiments, the pre-mix in the first package has a weight ratio of the POE to the hydrogenated block copolymer ranging from 1:5 to 5:1, or 1:3 to 3:1, or 1:1.

In embodiments, compounding is carried out at a temperature of 25 to 120°C using conventional mixing equipment, such as continuous single- or twin-screw mixers, static mixers, rubber mills, Brabender mixers, Buss kneaders, single screw extruders, twin screw extruders, heated or unheated two-roll mills.

The encapsulant film can then be formed from the compounded polymer composition by any suitable methods, including casting, electrospinning, extrusion, or compression molding, as well as various coating techniques such as dipping, flow coating, roll coating, bar coating, spray coating, curtain, rotogravure, brushing, wire wound rod coating, pan fed reverse roll coating, nip-fed coating, spraying, knife coating, spin coating, immersion coating, slot-die coating, ultrasonic spray coating. The film can be stand-alone layer or formed on a supporting substrate such as glass, plastic, ceramic, or porcelain. In embodiments, the encapsulant film is prepared at an ambient temperature (25°C) or at an elevated temperature ranging from 40 - 120°C, or 50 - 110°C, or 60 - 100°C, or 50 - 100°C, or 70 - 100°C, or > 50°C, or < 110°C, which is below the curing or cross-linking temperature.

In embodiments, the encapsulant film is cured by exposure to UV radiation, gamma radiation, electron-beam (EB), actinic radiation, or by thermal energy (heat).

In embodiments, thermal curing is carried out at a temperature of 80 - 220°C, or 90 - 200°C, or 100 - 180°C, or 110 - 170°C, or 120 - 160°C, or 130 - 180°C, or > 90°C, or < 200°C for 2 - 50 min, or 5 - 40 min, or 10 - 30 min, or 5 - 25 min.

In embodiments, the encapsulant film is prepared by compounding the polymer composition at a temperature of 120 - 180°C for 2 - 40 minutes, followed by hot compression molding of the resulting composition to form the encapsulant film.

(Properties of Encapsulant Films): Encapsulant films obtained from the polymer composition, after curing, exhibit improved adhesion to glass and silicon substrates, as well as enhanced transparency, heat stability, weatherability, and impact resistance. The encapsulant films also demonstrate balanced volume resistivity, water vapor transmission rate, and excellent resistance to potential induced degradation (PID).

In embodiments, the encapsulant film, after curing, has a thickness of 0.1 - 10 mm, or 0.15 - 8 mm, or 0.2 - 5 mm, or 0.1 - 3 mm, or 0.2 - 3.5 mm. The encapsulant film can consist of a single layer or multiple layers. When present in a multilayer structure, the total thickness of the encapsulant falls within the ranges described above.

Unless otherwise specified, the properties described below refer to the encapsulant film after curing.

In embodiments, the encapsulant film has a volume resistivity (expressed in units of ×10¹⁶ Ω·m) of > 1.0, or > 1.2, or > 1.4, or > 1.5, or < 8, or 1.0 - 8.0, or 1.2 - 7.0, or 1.4 - 6.0, or 1.5 - 5.5 Ω·m measured at 23°C, according to ASTM D257 (2 mm film thickness).

In embodiments, the encapsulant film has a transmittance of > 80%, or > 85%, or 80 - 99%, or 85 - 95%, or 87 - 93% measured with film thickness of 2 mm, according to ASTM D1003.

In embodiments, the encapsulant film has a clarity of > 40%, or > 45%, or 40 - 90%, or 45 - 80%, or 45 - 70% measured with a film thickness of 2 mm, according to ASTM D1003.

In embodiments, the encapsulant film has a static friction coefficient of > 0.39, or > 0.40, or > 0.42, or > 0.45, or > 0.50, or > 0.55, or < 1.5, or 0.39 - 1.5, or 0.40 - 1.0, or 0.42 - 0.90, measured on film-on-glass at 23°C and 0.3 mm thickness per ASTM D1894.

In embodiments, the encapsulant film has a dynamic friction coefficient of > 0.40, or > 0.45, or > 0.50, or > 0.55, or > 0.60, or > 0.70, or < 1.5, or 0.40 - 1.5, or 0.45 - 1.2, or 0.48 - 1.1, measured on film-on-glass at 23°C and 0.3 mm thickness per ASTM D1894.

(Applications): Encapsulant films obtained from the polymer composition can be used as PV encapsulant films, which can be applied on one side (front side) or both sides (front and back sides) of a PV module. The PV module incorporating the encapsulant film can be manufactured by any suitable lamination process, e.g., vacuum lamination, autoclave lamination, non-autoclave lamination, etc.

In embodiments, a PV module comprises a front cover, a plurality of photovoltaic cells or a photovoltaic cell array, a back sheet, and the encapsulant film. The encapsulant film is disposed between the front cover and the photovoltaic cells and/or between the photovoltaic cells and the back sheet, such that the photovoltaic cells are encapsulated within the module structure. As used herein, the term "front cover" refers to the transparent protective layer on the light-receiving side of the photovoltaic module and may be formed of glass or a transparent polymeric sheet. The term "back sheet" refers to the protective layer on the rear side of the module and may be a polymer laminate, an aluminum-based layer, or glass in glass-glass module constructions. The polymer composition can be used to form a first encapsulant film positioned between the photovoltaic cells and the front cover and, optionally, a second encapsulant film positioned between the photovoltaic cells and the back sheet. For proper module assembly and alignment, it is important that the encapsulant film or films possess sufficiently high static and dynamic friction coefficients to remain securely in place during lamination.

In addition to use in PV modules, the polymer composition can also be employed in other applications, such as wire and cable insulation, pipes, and hoses (including those for automobile radiators, potable water, and underfloor heating), roller coatings, rotational moldings, PV module back sheet, and cellular or foamed articles.

(Analytical Methods): The composition of the POE can be confirmed by spectroscopic analysis showing characteristic features of ethylene and α-olefin units. IR spectroscopy detects aliphatic C-H stretching absorptions near 2915 cm⁻¹ and 2848 cm⁻¹, consistent with ethylene-based polyolefins, together with spectral features attributable to C-H bending of higher α-olefins. NMR further confirms the identity of the comonomers present, with aliphatic resonances characteristic of ethylene-α-olefin copolymers. The amount of POE present can be determined by solvent extraction allowing quantification of the POE at or near 100 phr. Solvent extraction is first carried out to separate the POE from any hydrogenated block copolymer present in the film. The extracted POE fraction and the isolated residue are weighed to determine the relative proportions of the two polymers.

The solvent extracted samples can be subjected to gel-permeation chromatography (GPC) equipped with absolute molecular-weight detection to determine whether the block copolymer is a MABC or a HSBC. The HSBC materials exhibit a single and relatively narrow molecular-weight distribution with hydrodynamic dimensions characteristic of linear block architectures. In contrast, multi-arm copolymers of the structure (R)ₙX display a substantially higher apparent molecular weight and a reduced hydrodynamic volume that is diagnostic of a branched or star-like structure. These chromatographic features permit unambiguous differentiation between the MABC and HSBC species.

For the MABC, the average arm number n is determined by measuring the number-average molecular weight (Mₙ,star) of the intact polymer and comparing it to the number-average molecular weight (Mₙ,arm) of the individual R arms obtained after selective cleavage of the coupling core X. The cleavage treatment serves the R arms from the core while preserving the integrity of the blocks. After removal of core-derived fragments, GPC analyzes the liberated arms to obtain Mₙ,arm, and the average arm number n is calculated as Mₙ,star / Mₙ,arm.

For the HSBC, the structural features can be verified using spectroscopic and chromatographic techniques. The VAC can be measured by integration of aromatic proton resonances at approximately 6.2-7.2 ppm relative to aliphatic resonances in the ¹H NMR spectrum. A VAC of < 40 wt.% confirms the composition of the S blocks. The peak molecular weight (Mp) of each S block can be obtained by analyzing a styrenic fraction isolated through selective degradation or fractionation that removes hydrogenated diene segments. GPC analysis of this isolated styrenic fraction provides the S-block Mp, confirming that each S block has an Mp of < 30 kg/mol. Hydrogenation of the diene-derived R blocks can be confirmed by the absence of unsaturated proton signals or by the absence of IR absorptions characteristic of alkenyl C=C bonds.

Microscopy techniques such as TEM or AFM can further demonstrate the microphase-separated morphology of the dispersed hydrogenated block copolymer in the POE. The static and dynamic friction coefficients of the cured film can be determined according to ASTM D1894 on a glass substrate at 23°C using a film specimen with a thickness of 0.3 mm.

(Examples): The following examples are intended to be non-limiting.

The components used in examples include:
POE-1: ethylene-1-butene copolymer having MFI of 5 g/10 min at 190°C/2.16 kg, density of 0.877 g/cm³, melting temperature of 62°C, and T_{g} of -49°C, from LG Chem.
POE-2: ethylene-octene copolymer having MFI of 4.8 g/10 min at 190°C/2.16 kg, density of 0.872 g/cm³, melting temperature of 72°C, and T_{g} of -53°C, from Dow.
POE-3ethylene-1-butene copolymer having MFI of 5 g/10 min at 190°C/2.16 kg, density of 0.885 g/cm³, melting temperature of 63°C, and T_{g} of -44°C, from DL Chemical.
POE-4: alpha olefin copolymer having MFI of 18 g/10 min at 190°C/2.16 kg, density of 0.893 g/cm³, from Mitsui Chemicals.
MABC-1: multi-arm block copolymer having coupled hydrogenated polyisoprene arms (EP/MB)ₙX having MFR of 8 g/10 min at 200°C with 5 kg load, density of 0.900 g/cm³, CE of 95%, molecular weight (Mₚ) of MABC-1 of 488 kg/mol, and RU of 0.05 meq/g. MABC-1 has a number of E/P arms from 4 to 20.
HSBC-1: styrene-ethylene/propylene copolymer (S-EP/MB) having MFR of 1 g/10 min at 230°C/5 kg, molecular weight (Mₚ) of HSBC-1 of 127 kg/mol, molecular weight (Mₚ) of block "S" of 95 kg/mol, and VAC of 37 wt.%.
UV-1: 2-(2H-benzotriazol-2-yl)-4,6-ditertpentylphenol.
AO-1: antioxidant Irganox 1010 from BASF.
VTMOS: vinyltrimethoxysilane.
TBPB: tert-butyl peroxybenzoate.
TAIC: triallyl isocyanurate.

(Examples 1-10): Components of polymer compositions, in suitable amounts, were melt-mixed in Banbury mixer at 150°C for 2-5 minutes. The resulting compositions were then subjected to hot compression molding to obtain test specimens (encapsulant films or cured encapsulant films) having predetermined thicknesses suitable for the respective property measurements. Table 1 summarizes the polymer compositions and properties of encapsulant films.

In Table 1, Examples 1, 4, 7, and 9 are comparative examples containing only the POE, while Examples 2-3, 5-6, 8, and 10 are inventive examples containing MABC-1, HSBC-1, or both. The data show that, for each POE type, the addition of the hydrogenated block copolymer (e.g., MABC-1, HSBC-1) increases both static and dynamic friction coefficients, indicating reduced slipping and improved film stability during lamination. Comparisons are to be made between inventive and comparative examples using the same POE grade rather than across different POEs. The inventive films maintain high transmittance (about 90 %), comparable clarity, and similar volume resistivity (≈10¹⁶ Ω·m), confirming that optical transparency and electrical insulation are not affected by the additives. Overall, the inventive examples demonstrate improved anti-slip performance while retaining the desired optical and electrical properties of the base POE films.

Unless otherwise indicated, transmittance, clarity, and volume resistivity were measured using encapsulant films having a thickness of 2 mm. Static and dynamic friction coefficients were measured using encapsulant films having a thickness of 0.3 mm on a glass substrate. Transmittance and clarity were measured according to ASTM D1003, volume resistivity was measured according to ASTM D257, and static and dynamic friction coefficients were measured according to ASTM D1894.

**Table 1**

| | **Ex-1** | **Ex-2** | **Ex-3** | **Ex-4** | **Ex-5** | **Ex-6** | **Ex-7** | **Ex-8** | **Ex-9** | **Ex-10** |
|---|---|---|---|---|---|---|---|---|---|---|
| POE-1 (phr) | 100 | 100 | 100 | - | - | - | - | - | - | - |
| POE-2 (phr) | - | - | - | 100 | 100 | 100 | - | - | - | - |
| POE-3 (phr) | - | - | - | - | - | - | - | - | 100 | 100 |
| POE-4 (phr) | - | - | - | - | - | - | 100 | 100 | - | - |
| VTMOS (phr) | 0.5 | 0.5 | 0.5 | 0.5 | 0.5 | 0.5 | 0.5 | 0.5 | 0.5 | 0.5 |
| TBPB (phr) | 0.5 | 0.5 | 0.5 | 0.5 | 0.5 | 0.5 | 0.5 | 0.5 | 0.5 | 0.5 |
| TAIC (phr) | 0.5 | 0.5 | 0.5 | 0.5 | 0.5 | 0.5 | 0.5 | 0.5 | 0.5 | 0.5 |
| UV-1 (phr) | 0.2 | 0.2 | 0.2 | 0.2 | 0.2 | 0.2 | 0.2 | 0.2 | 0.2 | 0.2 |
| AO-1 (phr) | 0.2 | 0.2 | 0.2 | 0.2 | 0.2 | 0.2 | 0.2 | 0.2 | 0.2 | 0.2 |
| MABC-1 (phr) | - | 1.0 | 2 | - | 1.0 | 2 | - | 1.0 | - | 1.0 |
| HSBC-1 (phr) | - | 1.0 | - | - | 1.0 | - | - | 1.0 | - | 1.0 |

| **Properties** | | | | | | | | | | |
|---|---|---|---|---|---|---|---|---|---|---|
| Transmittance (%) | 91 | 91 | 92 | 91 | 90 | 91 | 90 | 88 | 90 | 87 |
| Clarity (%) | 54 | 52 | 54 | 50 | 50 | 50 | 50 | 48 | 46 | 47 |
| Volume resistivity (Ω·m) | 2.54 x 10¹⁶ | 2.03 x 10¹⁶ | 1.96 x 10¹⁶ | 2.15 x 10¹⁶ | 2.30 x 10¹⁶ | 2.01 x 10¹⁶ | 2.26 x 10¹⁶ | 2.51 x 10¹⁶ | 1.78 x 10¹⁶ | 2.66 x 10¹⁶ |
| Static friction coefficient | 0.42 | 0.48 | 0.45 | 0.76 | 0.78 | 0.79 | 0.39 | 0.41 | 0.37 | 0.44 |
| Dynamic friction coefficient | 0.47 | 0.49 | 0.5 | 0.85 | 0.92 | 0.94 | 0.49 | 0.65 | 0.43 | 0.70 |

## Claims

1. An encapsulant film for photovoltaic modules, comprising: 100 phr of a polyolefin elastomer comprising a copolymer of ethylene and at least one alpha-olefin having 3 to 20 carbon atoms; and
0.1 to 10 phr of a hydrogenated block copolymer selected from:
(i) a multi-arm hydrogenated block copolymer having a general structure ("R")ₙX, wherein X is a residue of a coupling agent and n is an integer from 4 to 20;
(ii) a hydrogenated styrenic block copolymer comprising at least one block "S" and at least one block "R," each block "S" is composed of vinyl aromatic units and has a molecular weight (Mₚ) of 70 to 130 kg/mol, measured according to ASTM D5296-19; and
(iii) mixtures thereof; and
wherein:
each block "R" comprises hydrogenated diene units; and
the hydrogenated styrenic block copolymer has a vinyl aromatic unit (VAC) content of < 40 wt.%, measured by 1H NMR; and
wherein after curing, the encapsulant film has a static friction coefficient > 0.39 and a dynamic friction coefficient > 0.45, both measured according to ASTM D1894.

2. The encapsulant film of claim 1, wherein the polyolefin elastomer has at least one of:
a melt flow index (MFI) of < 50 g/10 min, measured at 190°C with 2.16 kg load, according to ASTM D1238; and
a density of 0.860 to 0.910 g/cm³, measured according to ASTM D1505.

3. The encapsulant film of any of claims 1 or 2, wherein the polyolefin elastomer is selected from ethylene-1-butene copolymer, ethylene-octene copolymer, and mixtures thereof.

4. The encapsulant film of any of claims 1-3, wherein the hydrogenated block copolymer is a multi-arm hydrogenated block copolymer having a general structure ("R")ₙX,
wherein:
X is a residue of a coupling agent;
n is an integer from 4 to 20; and
"R" is selected from E/B, E/B/S, EP/MB, EP/MB/S, E/B/EP/MB, and combinations thereof, wherein:
each block E/B is composed of ethylene ("E") units and butylene ("B") units;
each block E/B/S is composed of ethylene ("E") units, butylene ("B") unit, and vinyl aromatic ("S") units;
each block EP/MB is composed of ethylene-propylene (EP) units and methylene-butylene (MB) units;
each block EP/MB/S is composed of ethylene-propylene (EP) units, methylene-butylene (MB) units, and vinyl aromatic ("S") units; and
each block E/B/EP/MB is composed of ethylene ("E") units, butylene ("B") units, ethylene-propylene (EP) units, and methylene-butylene (MB) units.

5. The encapsulant film of claim 4, wherein "R" is EP/MB and the multi-arm hydrogenated block copolymer has a general structure (EP/MB)ₙX.

6. The encapsulant film of any of claims 4-5, wherein the multi-arm hydrogenated block copolymer has a residual unsaturation (RU) of 0.01 to 1 meq/g and a molecular weight (Mₚ) of 300 to 700 kg/mol.

7. The encapsulant film of any of claims 1-3, wherein the hydrogenated block copolymer is a hydrogenated styrenic block copolymer having a general structure selected from: S-R, (S-R)ₙX, S-R-S, S-R-S-R, R-S-R-S-R, (R-S-R)ₙX, S-R-S-R-S, (S-R-S)ₙX, and mixtures thereof; wherein n is an integer from 2 to 30, and X is a residue of a coupling agent.

8. The encapsulant film of claim 7, wherein the hydrogenated styrenic block copolymer has a general structure S-R and wherein block "R" is an EP/MB block composed of ethylene-propylene (EP) units and methylene-butylene (MB) units.

9. The encapsulant film of any of claims 1-8, wherein the polyolefin elastomer and the hydrogenated block copolymer are present at a weight ratio of polyolefin elastomer to hydrogenated block copolymer of 100:0.1 to 100:20.

10. The encapsulant film of any of claims 1-9, further comprising, based on 100 phr of the polyolefin elastomer:
0.1 to 5 phr of at least one cross-linking agent selected from the group consisting of organic peroxides, sulfur based compounds, isocyanates, polycarbodiimides, metal-based catalysts, and mixtures thereof; and
0.1 to 10 phr of at least one additive selected from the group consisting of antioxidants, UV stabilizers, UV absorbers, moisture scavengers, metal deactivators, adhesion promoters, processing aids, acid scavengers, and mixtures thereof.

11. The encapsulant film of claim 10, wherein the cross-linking agent is an organic peroxide selected from dialkyl peroxides, alkyl aryl peroxides, diaryl peroxides,
hydrogen peroxides, diacyl peroxides, peroxy esters, ketone peroxides, peroxycarbonates, peroxy ketals, and mixtures thereof.

12. The encapsulant film of any of claims 1-11, wherein the encapsulant film has at least one of:
a volume resistivity of > 1.0 ×10¹⁶ Ω·m, measured at 23°C according to ASTM D257;
a transmittance of > 80%, measured according to ASTM D1003;
a clarity of > 40%, measured according to ASTM D1003;
a static friction coefficient of 0.39 to 1.5; and
a dynamic friction coefficient of 0.45 to 1.2.

13. A photovoltaic module, comprising:
a front cover;
a plurality of solar cells;
a back sheet; and
the encapsulant film of any of claims 1-12 disposed at least one of:
(i) between the front cover and the plurality of solar cells, and
(ii) between the plurality of solar cells and the back sheet.

14. A method of making an encapsulant film for use in photovoltaic modules, the method comprising:
providing a polymer composition comprising:
(a) 100 phr of a polyolefin elastomer containing a copolymer of ethylene and at least one alpha-olefin having from 3 to 20 carbon atoms,
(b) 0.1 to 10 phr of a hydrogenated block copolymer selected from:
(i) a multi-arm hydrogenated block copolymer having a general structure ("R")ₙX, wherein X is a residue of a coupling agent and n is an integer from 4 to 20;
(ii) a hydrogenated styrenic block copolymer comprising at least one block "S" and at least one block "R," each block "S" is composed of vinyl aromatic units and has a molecular weight (Mₚ) of 70 to 130 kg/mol, measured according to ASTM D5296-19; and
(iii) mixtures thereof; and
wherein:
each block "R" comprises hydrogenated diene units, and
the hydrogenated styrenic block copolymer has a vinyl aromatic unit (VAC) content of < 40 wt.%, measured by 1H NMR;
(c) 0.1 to 5 phr of a cross-linking agent; and
(d) 0.1 to 10 phr of at least one additive;
forming the encapsulant film by casting, electrospinning, extrusion, compression, or coating; and
curing the encapsulant film at a temperature of 80 to 220°C; and
wherein after curing, the encapsulant film has a static friction coefficient > 0.39 and a dynamic friction coefficient > 0.45, both measured according to ASTM D1894.

15. The method of claim 14, wherein providing the polymer composition comprises:
providing a masterbatch containing the polyolefin elastomer and the hydrogenated block copolymer in a weight ratio of 1:5 to 5:1; and
mixing the masterbatch with an additional amount of polyolefin elastomer to achieve a weight ratio of the polyolefin elastomer to the hydrogenated block copolymer of 100:0.1 to 100:20.
